(19) **Europäisches Patentamt**

**European Patent Office**

**Office européen des brevets**

(11) **EP 1 524 060 A2**

(12) **EUROPEAN PATENT APPLICATION**

(43) Date of publication:
**20.04.2005 Bulletin 2005/16**

(51) Int Cl.⁷: **B23K 3/06, H05K 13/00**

(21) Application number: **04017670.3**

(22) Date of filing: **07.11.2001**

(84) Designated Contracting States:
**DE FR GB IE IT**

(30) Priority: **10.11.2000 US 246899 P**
**22.08.2001 US 314240 P**

(62) Document number(s) of the earlier application(s) in accordance with Art. 76 EPC:
**01990052.1 / 1 332 654**

(71) Applicant: **Unitive Electronics, Inc.**
**Research Triangle Park, NC 27703 (US)**

(72) Inventor: **Rinne, Glenn A.**
**Apex, County of Wake, N.Carolina 27502 (US)**

(74) Representative: **Vigars, Christopher Ian**
**HASELTINE LAKE,**
**Redcliff Quay,**
**120 Redcliff Street**
**Bristol BS1 6HU (GB)**

Remarks:
This application was filed on 26 - 07 - 2004 as a divisional application to the application mentioned under INID code 62.

(54) **Methods of positioning components using liquid prime movers and related structures**

(57)    A liquid prime mover can be used to position a component on a substrate. For example, a liquid material can be provided on the substrate adjacent the component such that the component has a first position relative to the substrate. A property of the liquid material can then be changed to move the component from the first position relative to the substrate to a second position relative to the substrate. Related structures are also discussed.

**EP 1 524 060 A2**

**Description**

BACKGROUND OF THE INVENTION

Solder is used as an adhesive to attach optical fibers to a circuit board. Efforts to model the motion of an optical fiber during the wetting and solidification of the adhesive solder droplet are discussed in a reference by Adam Powell et al. entitled "*Mechanism Of Motion Of An Optical FiberAligned By A Solder Droplet*", Mat.Res.Soc.Symp. Proc., Vol. 531, 1998. The extent of motion is determined by several competing forces, during three stages of solder joint formation. First, capillary forces of the liquid phase control the fiber position. Second, during solidification, the presence of the liquid-solid-vapor triple line as well as a reduced liquid solder volume leads to a change in the net capillary force on the optical fiber. Finally, the solidification front itself impinges on the fiber. Publicly-available finite element models are used to calculate the time-dependent position of the solidification front and shape of the free surface.

Unfortunately, during the melting and solidification of the solder, significant motion of the fiber is observed to occur, decreasing the transmission efficiency. Because the capillary force on the fiber scales as its diameter and its stiffness as its diameter cubed, a very thin fiber is likely to be significantly deflected by the capillary force. Furthermore, as the solid joint solidifies, its volume changes, and with it the shape of the liquid surface and the magnitude of the capillary force on the fiber. Finally, as the solidified solder makes contact with the fiber, the shrinkage during cooling pulls the fiber further out of alignment.

EP 0939583 discloses a method of positioning a component on a substrate in which a liquid material is provided on the substrate adjacent the component.

SUMMARY OF THE INVENTION

According to one aspect of the present invention, there is provided a method of positioning a component on a substrate, the method comprising: providing a liquid material on the substrate adjacent the component such that the component has a first position relative to the substrate; and moving the component from the first position relative to the substrate to a second position relative to the substrate by changing a property of the liquid material while maintaining the liquid material in a liquid state.

According to another aspect of the present invention, there is provided a structure for positioning a component provided, on a substrate, the structure comprising: a substrate; a first wettable area on the substrate; a second wettable area on the substrate; a wettable channel on the substrate coupling the first and second wettable areas; liquid material, for carrying a component, on the first wettable area; and a flow control dam on the wettable channel wherein the flow control dam prevents flow of liquid between the first and second wettable areas.

BRIEF DESCRIPTION OF THE DRAWINGS

Figures 1A-C are plan and cross-sectional views illustrating a vertical displacement of components by changing liquid volumes according to embodiments of the present invention.
Figures 2A-C are plan and cross-sectional views illustrating lateral displacement of components by changing liquid volumes according to embodiments of the present invention.
Figures 3 and 4A-C are perspective and cross-sectional views illustrating displacements of fibers using elongate liquid bumps according to embodiments of the present invention.
Figure 5 is a perspective view of adding liquid to a liquid bump according to embodiments of the present invention.
Figures 6A-E are plan and cross-sectional views illustrating sumps and reservoirs according to embodiments of the present invention.
Figure 7 is a plan view illustrating alternative examples of reservoirs according to embodiments of the present invention.
Figures 8-11 are cross-sectional views illustrating displacement of components using liquid bumps according to embodiments of the present invention.
Figures 12A-E and 13A-E are plan and cross-sectional views illustrating movement of liquid on a constrained symmetric surface using a temperate differential across the liquid according to embodiments of the present invention.
Figures 14A-C are plan and cross-sectional views illustrating movement of liquid on an asymmetric surface by changing a temperature of a uniformly heated liquid according to embodiments of the present invention.
Figures 15A-C are plan and cross-sectional views illustrating movement of liquid on an asymmetric surface using a temperature differential across the liquid according to embodiments of the present invention.

Figure 16 is a graph illustrating internal pressure of a liquid as a function of liquid bump height.

Figures. 17A-C are plan and cross-sectional views illustrating movement of solder to switch light according to embodiments of the present invention.

## DETAILED DESCRIPTION

The present invention now will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. In the drawings, the thickness of layers and regions are exaggerated for clarity. Like numbers refer to like elements throughout. It will be understood that when an element such as a layer, region or substrate is referred to as being "on" another element, it can be directly on the other element or intervening elements may also be present. In contrast, when an element is referred to as being "directly on" another element, there are no intervening elements present. Also, when an element is referred to as being "bonded" to another element, it can be directly bonded to the other element or intervening elements may be present. In contrast, when an element is referred to as being "directly bonded" to another element, there are no intervening elements present.

According to embodiments of the present invention, a component such as an optical fiber, a lens, a laser, a light emitting diode, an integrated circuit device, and/or a microelectronic, micro-mechanical, and/or micro-optical device can be precisely positioned on a substrate by changing a property of a liquid material adjacent the component. More particularly, a liquid material can be provided on the substrate adjacent the component such that the component has a first position relative to the substrate. A property of the liquid material can then be changed while maintaining the liquid material as a liquid to move the component from the first position relative to the substrate to a second position relative to the substrate.

For example, a high degree of precision and small movements may be desired for alignment of an optical component on an optical module substrate, and a rigid locking or clamping mechanism may be desired to maintain the alignment of the component once achieved. Materials that can transition in phase from a liquid or fluid-like state (referred to hereinafter as liquid) to a rigid state are well suited to provide alignment of the component in the liquid state and then to secure the component in the aligned position in the rigid state. Examples of such materials include solder, thermoplastics, UV-curable epoxies, snap-cure epoxies, and others.

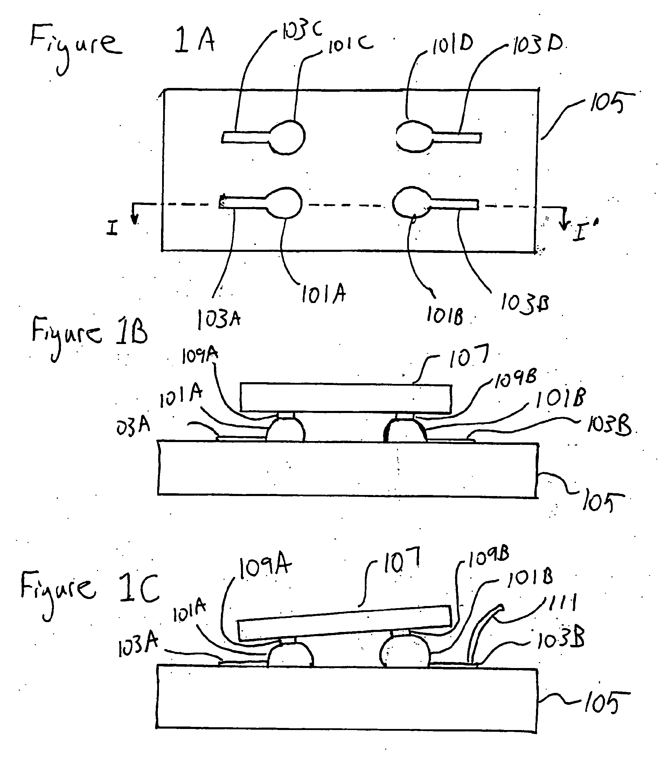

To effect movement of the component for alignment, a liquid prime mover can be used. Since the attachment or clamping material is in the liquid state during the positioning phase, the internal pressure caused by the surface tension of the liquid can be used as a prime mover. As shown in Figures 1A-C, for example, one or more molten (liquid) solder bumps **101A-D** could be increased in volume by adding solder to the bump. Solder can be added to one or more of the solder bumps **101A-D**, for example, by feeding a solder wire into a relatively narrow feeder portion **103A-D** such that the new solder flows to the respective bump **101A-D** upon melting and the larger bump causes the component **107** on the bumps to rotate. Three such bumps under the component could define a plane and, thus, control total height and angular orientation of the component **107** relative to the substrate **105**. Note that the bumps need not have a circular base, but can be any shape useful for a particular application (e.g., oblong, rectangular, triangular).

As shown in Figure 1A, a substrate **105** can include one or more solder bumps **101A-D** used to secure a component **105** to the substrate, and one or more of the solder bumps can have an associated feeder portion **103A-D** used to feed solder to the respective solder bump. Each of the solder bumps and associated feeder portions is formed on a wettable area of the substrate 105, and the wettable area of the substrate is used to confine the lateral dimensions of the solder bumps and feeder portions so that the solder bumps are confined to a relatively wide dimension on the substrate and so that the feeder portions are confined to relatively narrow dimensions on the substrate. Accordingly, molten solder will flow from a relatively narrow feeder portion to a respective relatively wide solder bump. The flow of molten solder from relatively narrow portions to relatively wide portions is discussed, for example, in US Patent No. 5, 892,179 entitled "*Solder Bumps and Structures for Integrated Redistribution Routing Conductorsl*" and assigned to the assignee of the present invention.

As shown in cross section in Figure 1B, a component 107 including wettable pads 109A-D corresponding to solder bumps 101A-D can be aligned with the substrate 105 using molten solder bumps 101A-D. More particularly, the wettable pads are brought into contact with the respective molten solder bumps, and the interaction of the wettable pads and the molten solder bumps will bring the component into alignment with the solder bumps. The component, however, may not have a desired alignment with respect to the substrate after initial alignment because of inaccuracies in the initial size of the solder bumps. The component, for example, may be a laser diode, and precise positioning of the laser diode may be desired to accurately project the laser output relative to the substrate.

Additional solder may be added to one or more of the feeder portions to selectively increase the size of the respective solder bump thereby raising the portion of the component adjacent to the solder bump having increased solder. As shown in Figure 1 C, additional solder from solder wire 111 can be fed through feeder portion 103B to the solder bump 101 B. Because the size of solder bump 101 B is increased while the size of solder bump 101 A is not increased, an angular orientation of component 107 is changed relative to the substrate 105. Solder can be added to additional solder bumps to further adjust the height and/or angular orientation of the component. If the component is a laser diode, for example, the laser output can be monitored while adjusting the angular orientation thereof to obtain a desired orientation of the laser output. Once the desired orientation of the component is achieved, the molten solder bumps can be cooled to a solid state thereby securing the component to the substrate in the desired orientation.

By providing at least three solder bumps with feeder portions, the height and angular orientation of the component can be controlled relative to the substrate. While four solder bumps are illustrated in Figures 1A-C, as few as one solder bump with a feeder portion or more solder bumps with feeder portions can be provided according to embodiments of the present invention. Moreover, not all solder bumps according to embodiments of the present invention are required to have respective feeder portions, and it may not be necessary to provide the ability to adjust the volume of all solder bumps coupling the component to the substrate. In addition, solder may be added to solder bumps by means other than a feed wire and a feeder portion. Precise volumes of liquid solder, for example, can be jetted to a feeder portion or directly to a solder bump. Solder reservoirs and/or sumps can also be used to change the volume of a solder bump as discussed in greater detail below.

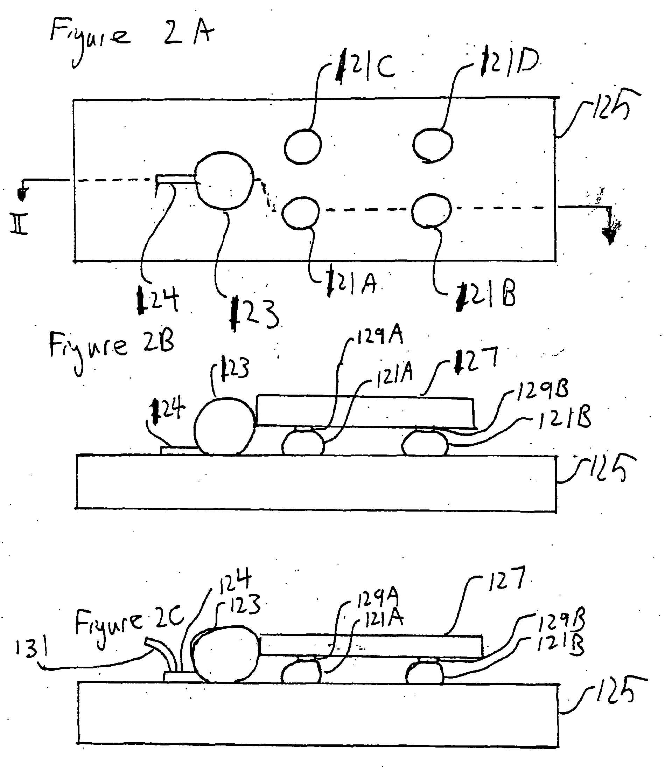

As shown in Figures 2A-B, a liquid prime mover can alternately be used to effect lateral movement of a component on a substrate. Solder bumps **121A-D** can be provided on substrate **125** to secure a component **127**. Solder bumps **121A-D** can also provide an electrical coupling between the substrate and the component. Embodiments illustrated in Figures 2A-B can also include a prime mover such as solder bump **123** to effect lateral displacement of the component **127**. A relatively narrow feeder portion **124** can be used to feed solder to the solder bump **123** thereby increasing the size of the solder bump **123** and displacing the component **127** to the right as shown in Figure 2C.

More particularly, molten (liquid) solder bumps **121A-D** can be provided between wettable pads **129A-D** of the component **127** and the substrate **125**. Wettable areas of the substrate **127** can be used to define the surface area of the substrate to which the bumps **121** will be confined. Surface tension of the bumps **121** will define a rough alignment of the component as discussed above with regard to Figures 1A-C.

Lateral alignment of the component **127** can be effected by changing a property of the bump **123**. Volume can be added to the bump **123**, for example, by adding material to the bump **123** through the relatively narrow feeder portion **124** thereby displacing the component **127**. More particularly, the component can be positioned on molten (liquid) solder bumps **121A-D** with the solder bump **123** having a first volume as shown in Figure 2B. As long as the solder bumps **121A-D** are molten (liquid), the component can be moved by adding volume to the solder bump **123**, for example, by feeding solder wire **131** into the relatively narrow feeder portion **124** so that molten (liquid) solder from the wire flows to the solder bump **123** as shown in Figure 2C. Once a desired degree of displacement has been effected, the solder bumps **121A-D** can be solidified by cooling to secure the component **127** in the desired orientation relative to the substrate **125**.

As discussed above, the volume of the solder bump can be changed by means other than the melting of a solder wire onto a relatively narrow feeder portion. Precise volumes of liquid solder, for example, can be jetted to a feeder portion or directly to a solder bump. Alternately, solder reservoirs and/or sumps can be used to change the volume of a solder bump. In addition, other properties of a liquid prime mover can be changed to effect movement of the component. For example, temperature, electrical potential, surface tension, differences in wettable areas, and combinations thereof can be used to manipulate a liquid prime mover as discussed in greater detail below. While a single solder bump **123** is shown to effect lateral.movement of the component, a plurality of solder bumps can be provided to effect lateral movement of the component.

Moreover, aspects of embodiments illustrated in Figures 1A-C and 2A-C can be combined. Volume of one or more of solder bumps **121A-D** of Figures 2A-C can be changed to adjust an angular alignment of the component **127** with respect to the substrate, while changing the volume of solder bump **123** to change a lateral displacement of the component. Moreover, liquid prime movers other than solder can be used to adjust position of the component, and properties of the liquid prime mover other than volume can be used to effect movement of the component.

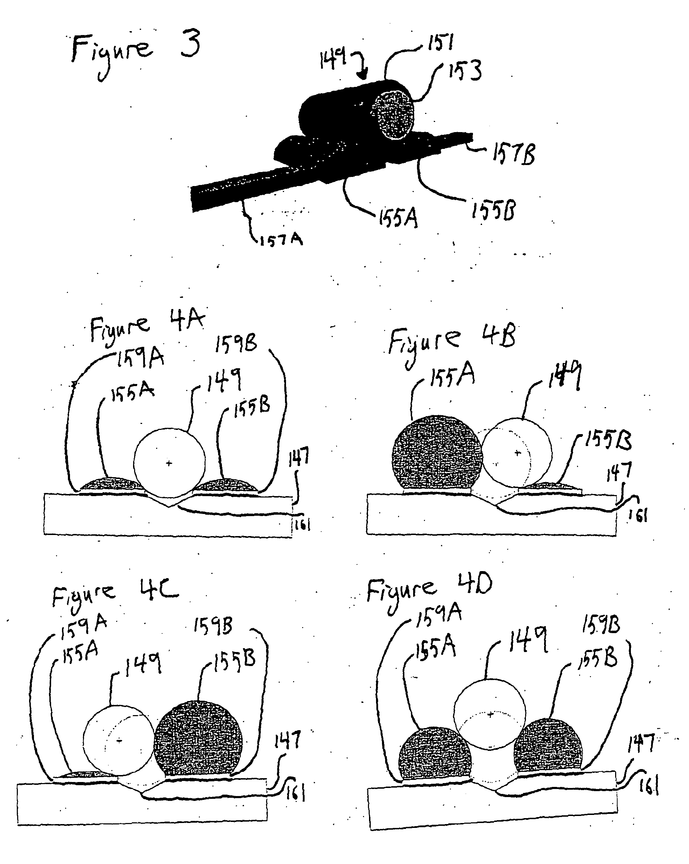

According to additional embodiments, the hydrostatic pressure of a liquid can be used as a prime mover in the positioning of non-planar components such as fibers and lenses. By changing the size or extent of a liquid bump, the pressure of the liquid can displace a component laterally as well as vertically. As shown in Figure 3, a position of an optical fiber **149** including an outer cladding **151** and an inner core **153** can be governed by the elongate semi-cylindrical liquid bumps **155A-B** provided on a substrate. The elongate liquid bumps **155A-B** may be referred to as vesicles or liquid-filled sacs because the surface tension of many materials that can be used to form the elongate bumps may form a tenacious skin that acts like a bag or sac. By providing a liquid prime mover that is not wettable to the outer cladding **151** of the optical fiber **149**, the optical fiber can be supported between the two elongate liquid bumps **155A-B**. Once a desired position of the optical fiber **149** is achieved, the elongate liquid bumps can be solidified by cooling to secure the optical fiber in the desired position.

By way of example, the elongate bumps **155A-B** can be elongate solder bumps provided on wettable contact pads of a substrate, and relatively narrow feeder portions **157A-B** can be used to add solder to the respective elongate bumps **155A-B**. The narrow feeder portions **157A-B** are confined to respective narrow wettable contact pads of the substrate so that solder will flow from the relatively narrow feeder portions to the elongate solder bumps **155A-B**. Accordingly, adding equal amounts of solder to both elongate solder bumps **155A-B** can raise the optical fiber **149** vertically without significant lateral displacement. Adding more solder to one of the elongate solder bumps can displace the optical fiber laterally. As discussed above with respect to Figures 1A-C and 2A-C, solder can be added through the respective feeder portions **157A-B**, or solder can be added directly to either of the elongate solder bumps **155A-B**. Alternately, solder reservoirs and/or sumps can be used to change a volume of solder of either of the elongate solder bumps **155A-B**.

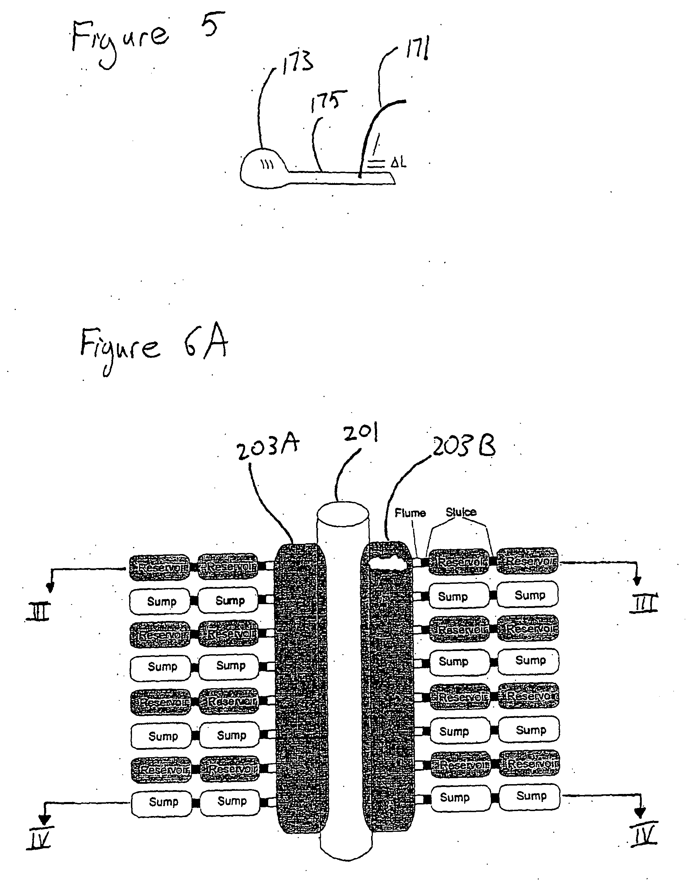

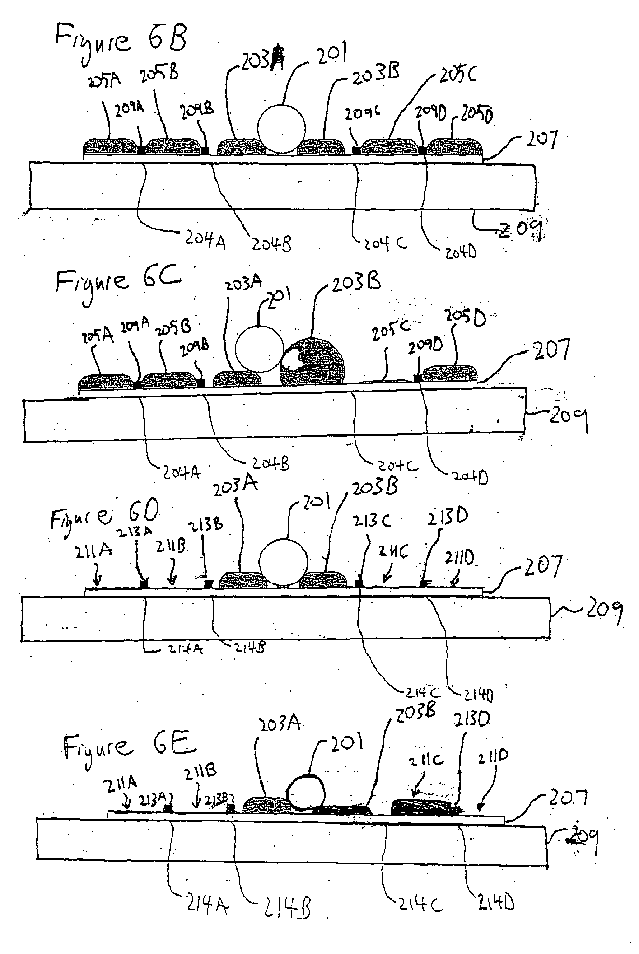

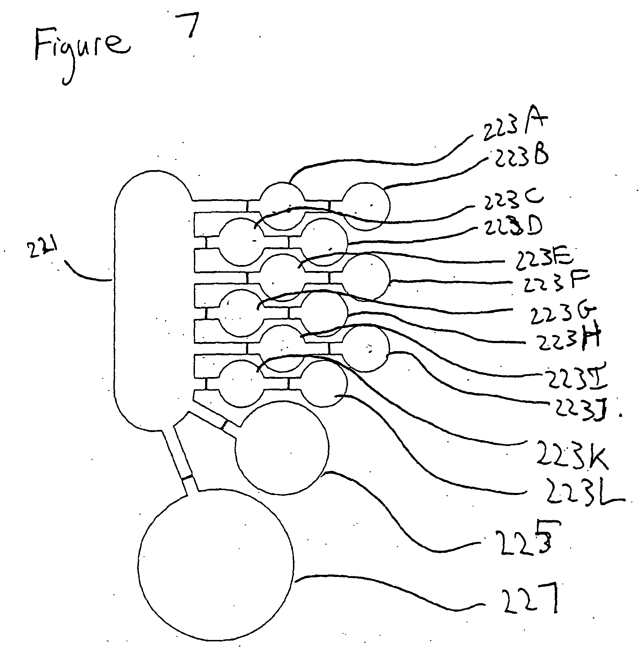

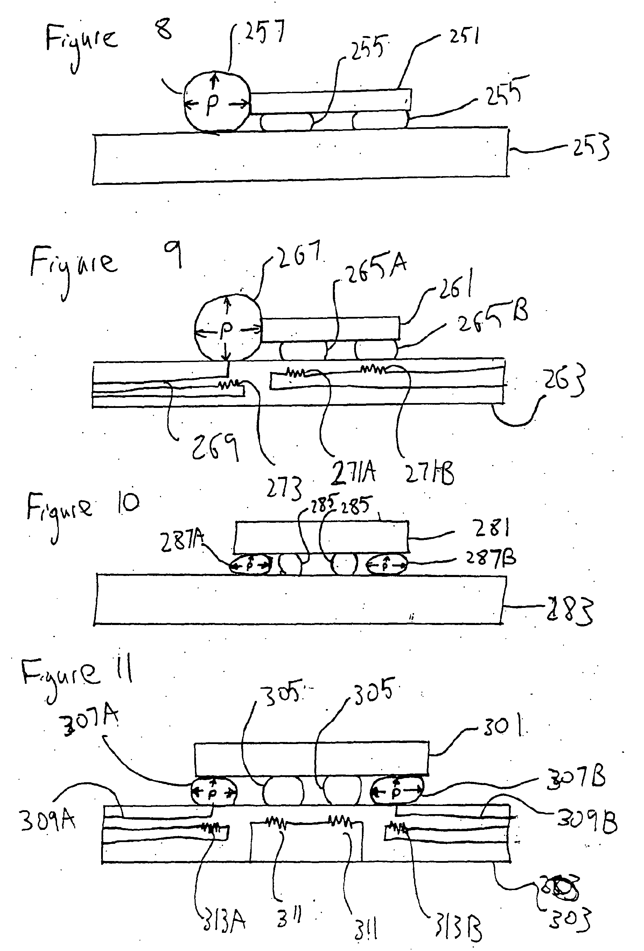

As shown in Figures 4A-D, elongate liquid bumps can be used to effect precise positioning of an optical fiber **149**. An optical fiber **149** can be placed between two elongate liquid bumps **155A-B** confined to respective wettable contact pads **159A-B** of a substrate **147**, as shown in Figure 4A. An optional pre-alignment groove **161** in the substrate is shown. As additional molten (liquid) solder is added to one of the elongate pads, the volume increases and the bump grows as shown in Figures 4B-C. Since the liquid does not wet the optical fiber **149** surface, the fiber is forced aside. If more liquid is added to one elongate liquid bump than the other, a lateral displacement of the optical fiber **149** can be effected as shown in Figures 4B-C. If both elongate liquid bumps **155A-B** have equal amounts of liquid added, the net motion is a vertical translation as shown in Figure 4D.

Significant force can be generated by the relatively small elongate liquid bumps of Figures 3 and 4A-D. A 50 μm tall elongate solder bump on a 5 mm long 100 μm wide oblong wettable pad can exert a force of 1 gmf on an adjacent fiber. This force is sufficient to deflect a 62.5 μm diameter silica optical fiber by 1 μm.

Fibers illustrated in Figures 3 and 4A-D could be replaced with another non-planar component such as a lens. Alternatively, components such as lasers or diodes that are soldered to the substrate could be 'nudged' into proper position by varying the volume of adjacent liquid bumps.

As discussed above with regard to Figures 1-4, the volume of a liquid bump can be increased to precisely position a component on a substrate. In various examples, molten (liquid) solder has been discussed as a liquid that could be used. Other liquid materials such as thermoplastics and epoxies, however, could be used to position components.

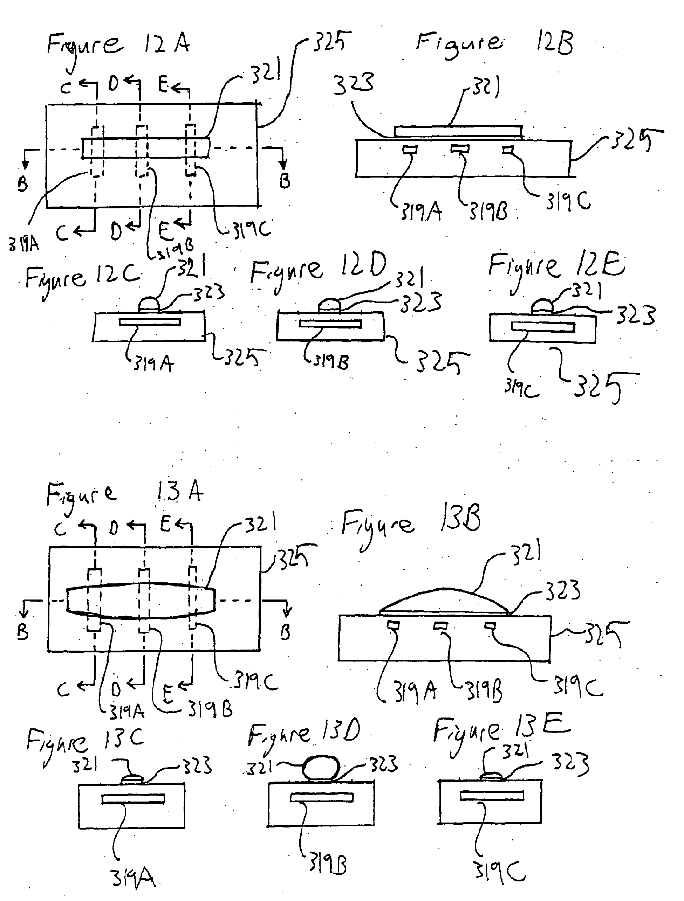

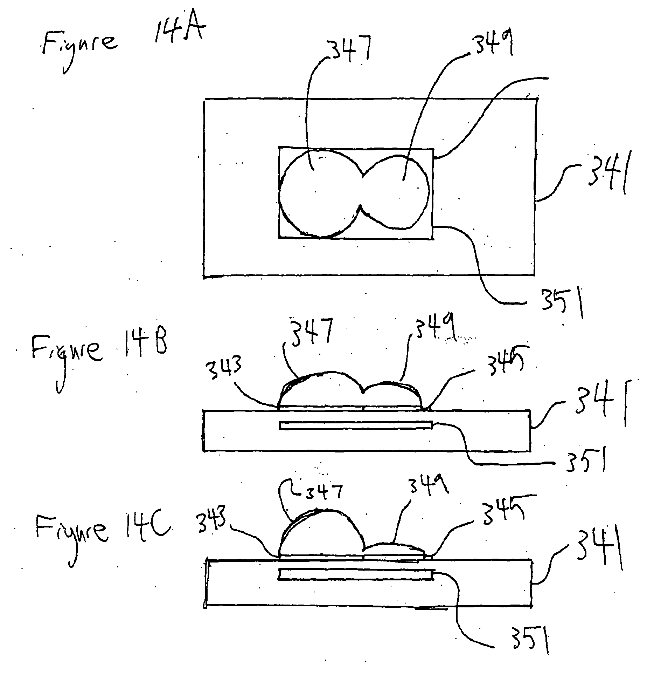

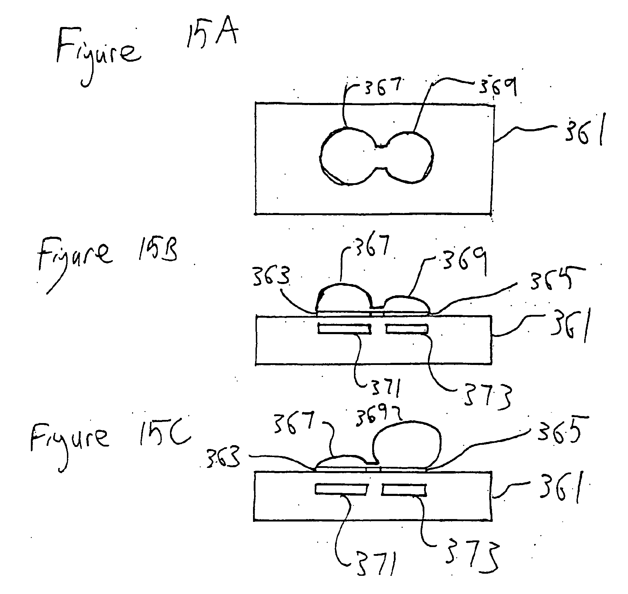

When adding liquid to a bump through a relatively narrow feeder portion, the resulting volume added can be calculated as discussed below with regard to Figure 5. While other materials can be used, solder will be discussed by way of example. As shown in Figure 5, a thin solder wire **171** can be used to add solder to a liquid solder bump **173** through a relatively narrow feeder portion **175**.

Calculation of the change in solder volume of a 5mm long by 0.05 mm wide hemispherical solder bump **173** when a 12.5 micron (0.5 mil) diameter solder wire **171** is introduced through the relatively narrow feeder portion **175** indicates that the volume of the liquid solder bump **173** can increase 0.2% for every micron of wire **171** consumed. If 25μm of wire is fed into the liquid solder bump **173**, the radius of the bump **173** would increase by approximately 0.75μm.

Solder could also be added to a liquid solder bump by droplets in the liquid state, as in liquid metal jetting for which picoliter drop sizes have been demonstrated. Likewise, a syringe could dispense controlled volumes of solder. It is even possible to electrochemically deposit additional solder using molten salt electrolytes in a manner similar to brush plating. Conceivably, other deposition methods could be employed such as solid preforms, powders, pastes, crèmes, spheres, or vapors.

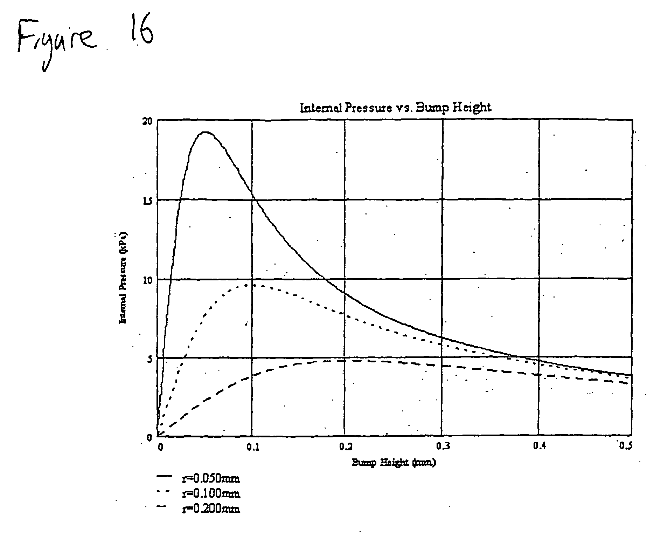

Sumps and/or predeposited solder reservoirs can also be used to adjust the volume of one or more solder bumps as illustrated in Figures 6A-D. As shown, an optical fiber **201** can be positioned between two elongate solder bumps **203A-B**. The elongate solder bumps **203A-B** are connected via wettable channels **204A-D** and **214A-D** also referred to as 'flumes' defined by portions of a patterned solder wettable layer **207** to reservoirs **205** and sumps **211**. At the output of each reservoir **205** or sump **211** there is a flow-control dam **209** also referred to as a 'sluice'. The patterned solder wettable layer **207** defines areas within which solder bumps **203A-B**, solder reservoirs **205**, and sumps **211** will be confined, and solder does not flow outside the areas defined by the solder wettable layer **207** because adjacent areas of the substrate **209** are not wettable to solder.

The flow-control dams **209** comprise a non-wettable material and can thus reduce the flow of solder through the wettable channels. In an initial state illustrated in Figures 6B and 6D, flow-control dams **209A-D** stop the flow of predeposited solder from solder reservoirs **205A-D** to elongate solder bumps **203A-B**, and flow control dams **213A-D** stop the flow of solder from elongate solder bumps **203A-B** to sumps **211A-D**.

Structures illustrated in Figures 6A-E can thus be used to increase and/or decrease a volume of solder in the elongate solder bumps **203A-B** by selectively removing flow-control dams and reflowing the solder. As discussed above, flow-control dams have a low wettability with respect to solder to stop a flow of solder through a respective wettable channel, and the flow-control dams can include materials such as metal oxide, glass, and/or a polymeric solder mask. Likewise, flow-control dams can be used to stop a flow of solder to respective sumps.

When a flow of solder past a flow-control dam is desired, the wettability of the channel at the flow-control dam can be increased. This increase in wettability can be accomplished by mechanically removing the flow-control dam such as by scratching, milling, and/or sandblasting the flow-control dam. Photomechanical techniques such as ablation, localized heating, and photo- or thermal-decomposition can also be used to remove a flow-control dam. Alternatively, chemical techniques such as etching to remove the flow-control dam or coating the flow-control dam with a lower surface energy material to improve wettability over the flow-control dam can be used. A bridge, for example, can be formed across a flow-control dam (or across a gap in the patterned wettable layer **207**) by placement of a wettable fiber, droplet or channel. In addition, electrostatic and/or electromagnetic techniques could cause perturbations in the reservoir, creating waves that bridge across the flow-control dam or gap. Mechanical vibrations, thermal shocks, moving paddles, squeegees, and other means can be used to encourage movement of solder until it bridges the flow-control dam or gap. The solder could alternatively be squeezed by pressing with a plunger to force the solder to bridge the gap.

Moreover, the flow of liquid from a reservoir to a bump or from a bump to a sump can be controlled using electrowetting. A channel between a bump and a reservoir or a sump can be provided with a semi-wettable material, for example, and the wettability of the semi-wettable channel can be increased by electrically charging the liquid of the bump and/or reservoir. Alternatively or in addition, the flow of liquid from a reservoir to a bump or from a bump to a sump can be controlled using differential heating as discussed below with respect to Figures 12A-E, 13A-E, 15A-E, and 17A-E; or using uniform heating as discussed below with respect to Figures 14A-C. Meta-stable conditions can also be used to control liquid flows as discussed below with respect to Figures 15A-C and 17A-C.

As shown in Figures 6A-C, a solder reservoir **205A-D** can be predeposited with a volume of solder at the time the elongate solder bumps **203A-B** are deposited. As shown in Figure 6B, the optical fiber **201** is placed between the elongate solder bumps **203A-B**, and if the solder is heated to its melting temperature, the flow-control dams **209A-D** can stop the flow of solder from the reservoirs to the elongate solder bumps. If the optical fiber is to be laterally displaced, additional solder volume can be added to the elongate solder bump **203B** to displace the optical fiber to the left as shown in Figure 6C. More particularly, the flow-control dam **209C** can be removed so that when the solder is heated to its melting temperature, solder will flow from the solder reservoir **205C** to the elongate solder bump **203B** due to the geometries of the elongate solder bump, the reservoir, and the wettable channel coupling the elongate solder bump **203B** and the solder reservoir **205C**.

More particularly, the relative widths of the portions of the solder wettable layer **207** defining the wettable channels and the solder reservoirs can be narrow relative to the width of the elongate solder bump so that molten solder flows to the wider elongate solder bump as discussed in U.S. Patent No. 5,892,179 entitled *"Solder Bumps And Structures For Integrated Redistribution Routing Conductors"* and assigned to the assignee of the present invention. Any number of flow-control dams can be removed to allow the flow of solder from solder reservoirs to. the respective elongate solder bump to increase the volume of the elongate solder bump by predetermined increments.

As shown in Figure 6A and 6D-E, little or no solder is deposited on the sumps **211A-D** prior to positioning the optical fiber **201** between the elongate solder bumps **203A-B**. If it is desired reduce a volume of one of the elongate solder bumps **203A-B**, one or more of the flow-control dams **213A-D** blocking the sumps **211A-D** can be removed thereby allowing solder to flow from an elongate solder bump to one or more sumps. As shown in Figures 6D-E, the flow-control dam **213C** between the elongate solder bump **203B** and the sump **211C** can be removed thus allowing solder to flow from the elongate solder bump **203B** to the sump **211C**. In the example of Figure 6E, the optical fiber **201** can be laterally displaced to the right.

According to embodiments of the present invention, a sump can be designed to have a lower radius of curvature than the corresponding elongate solder bump such that the internal pressure is lower in the sump until the sump is full. While the plan view of Figure 6A shows the sumps and reservoirs as geometrically similar, it is possible to provide different geometries for reservoirs and sumps to increase a flow of solder from a reservoir to a bump and to increase a flow of solder from a bump to a sump. A reservoir, for example, may be provided on a portion of a solder wettable layer having a relatively narrow dimension with respect to the corresponding bump to increase flow to the bump. In contrast, a sump may be provided on a portion of a solder wettable layer having a relatively wide dimension with respect to the corresponding bump to increase flow to the bump.

According to embodiments illustrated in Figures 6A-E, incremental operations of removing flow-control dams and reflowing solder can be used to precisely control the volumes of elongate solder bumps **203A-B**. Once desired volumes of the elongate solder bumps are achieved, the solder bumps can be solidified by cooling to maintain the optical fiber in a desired position. While the sumps and reservoirs are illustrated in Figure 6A as being provided together on a substrate, embodiments of the present invention can be implemented with only one or more reservoirs and no sumps, or with only one or more sumps and no reservoirs. Moreover, sumps and/or reservoirs of different sizes can be provided to reduce and/or increase different volumes of solder. In addition, sumps and/or reservoirs can be used to change volumes of solder in bumps having geometries other than that of the elongate bumps of Figures 6A-E and to position components other than optical fibers. Sumps and/or reservoirs, for example, can be used to change volumes of bumps such as those illustrated in Figures 1A-C and 2A-C.

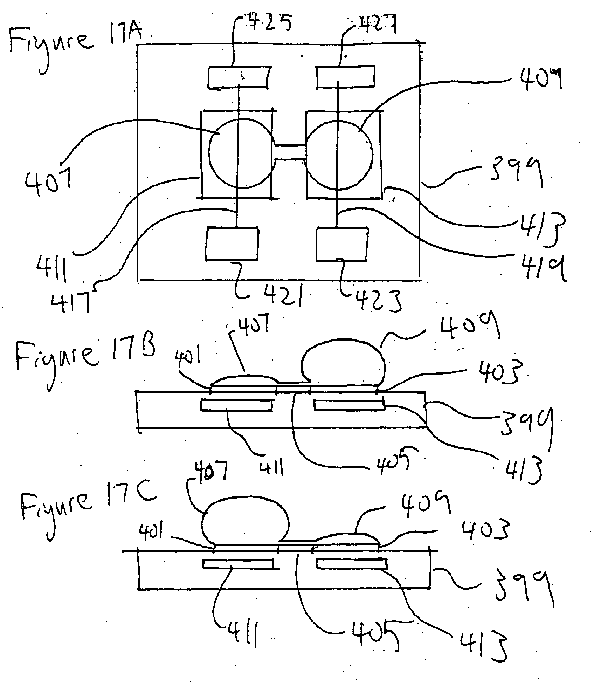

According to embodiments illustrated in Figure 7, reservoirs of different sizes can be provided so that discrete volumes of solder can be added to the elongate solder bump **221**. In the particular example of Figure 7, the bump **221** is connected through channels to the reservoirs of differing sizes. For scale, reservoirs **223A-L** can be 125 µm in diameter, reservoir **225** can be 1000 µm in diameter, and reservoir **227** can be 2500 µm in diameter. Accordingly, the radius of bump **221** can be increased over a range of 10µm in 0.25 µm steps. Bumps and reservoirs of different sizes as illustrated in Figure 7 can be used as prime movers in any of the embodiments illustrated in Figures 1A-C, 2A-C, 3, 4A-C, and/or 6A-E. Such bumps can have different geometries than the elongate bump illustrated in Figure 7, and reservoirs with sizes and shapes different than those illustrated in Figure 7 can be provided. Sumps of different sizes can alternately be used to provide decreases over a predetermined range in predetermined steps.

While the use of reservoirs and sumps to vary the size of a bump is discussed with reference to Figures 6A-E and 7 for the purpose of positioning a component, reservoirs and sumps can also be used to provide bumps of precise size without necessarily changing a position of a component. To their knowledge, the Applicant is the first to realize that solder sumps and reservoirs can be used to provide bumps of precise size.

While examples of the present invention are discussed above as including solder bumps, other liquids such as thermoplastics and epoxies can be used to position components according to embodiments of the present invention. As discussed above, a change in displacement of a component can be effected by changing a volume (size) of a liquid bump in contact with the component. For example, the surface tension of a liquid bump in contact with a component can result in a pressure exerted on the component, or an increase in a size of the liquid bump can increase a pressure exerted on the component to move the component. Similarly, a decrease in the size of a liquid bump can decreases a pressure exerted on the component to move the component in the opposite direction. While the pressure exerted by a liquid bump against a component can be increased or decreased by increasing or decreasing a size of the bump as discussed above, the pressure exerted by a bump can also be increased or decreased by changing the surface tension of the liquid bump as discussed in greater detail below. Moreover, a mere change in volume of a liquid bump can be used to displace a component.

When used as a prime mover, a liquid bump according to embodiments of the present invention can provide force to move a component using pressure resulting from surface tension. The Young-Laplace equation relates this pressure $P$ to the surface tension $\gamma$, and the major and minor radii of curvature according to the following equation:

$$P = \gamma \cdot \left[ \frac{1}{r_1} + \frac{1}{r_2} \right].$$  [1]

A change one or more of the three variables can thus be used to change a pressure exerted by a liquid bump.

The concept of surface tension relates to an interface between two bodies. Changes in a liquid-air interface between solder and air can thus change a.surface tension of the solder. Changes in solid-liquid and liquid-liquid interfaces can also be used to change a surface tension of a solder. A surface tension of a material is a function of the material with which it is in contact and the temperature. Accordingly, to vary the surface tension, either the material of the liquid bump (e.g., indium $\gamma$ = 592 dyne/cm has higher surface tension than either lead $\gamma$ = 530 dyne/cm or tin $\gamma$ = 480 dyne/cm) can be changed, or the material in contact with the liquid bump (e.g., tin in air $\gamma$ = 417 dyne/cm vs. tin in nitrogen $\gamma$ = 464 dyne/cm at 250°C) can be changed, or the temperature of the liquid bump can be changed. For example, different reservoirs could contain different materials such that $\gamma$ could be changed simultaneously with the volume. Since the surface of liquid metal may oxidize readily, the oxygen content of the surroundings could be controlled with addition of oxygen being used to increase $\gamma$. Similarly, an environment surrounding a liquid solder bump could be flooded with a liquid or vapor phase reductant such as acid or hydrogen, to reduce surface oxides. A liquid-liquid interface could be formed by immersion in a liquid with a high boiling point such as glycerin.

When an oxidized surface of a liquid bump is used to change a surface tension of the bump, the surface of the bump actually comprises a material (oxide) different than that of the liquid bump. Alternatively, a flexible material can be provided over an initial bump, and the bump can be used to inflate or deflate the flexible material with the addition or removal of solder.

In addition, the radius of curvature of the surface of a liquid bump (such as a molten solder bump) is a function of the amount of liquid, the wetted area on the substrate, and the wetting angle at the solder-substrate-air interface. All three of these variables can be controlled.

The wetting angle depends on the 'wettability' of the substrate. Any of the methods mentioned above to control the flow of solder in the wettable channels of Figures 6A-E and 7 could be used to control the wettability of the substrate.

The wetted area can be controlled much like the wettable channels as well. A solder dam around the base of the liquid bump could be moved or removed to expose more or less wettable area of the substrate to the liquid bump. A non-wettable surface covered by a wettable, removable surface is one means for reducing the wetted area. The volume of the liquid bump can be adjusted with the addition or removal of liquid as discussed above.

As discussed above, surface tension and/or pressure of liquid phase materials can be exploited as a prime mover on the millimeter and micron scale. Forces on the order of grams per sq. mm can be generated with displacements of tens of microns. Such structures may be useful for positioning of components on substrates. The present application describes methods, structures, and apparatuses for employing this mechanism on planar substrates. Techniques according to aspects of the present invention can also be used on non-planar surfaces.

The addition or removal of liquid from a liquid bump can thus be used to position a component. Other properties of a liquid bump can alternately be used to position a component. As illustrated in Figure 8, a component **251** can be secured to a substrate **253** using an adhesive **255**, and a pressure **P** exerted by a liquid bump **257** can be used to position the component **251**. More particularly, the adhesive **255** may be in an initial liquid or fluid like state such that the component is roughly aligned yet moveable with respect to the substrate. The adhesive, for example, can be a curable epoxy in an initially uncured state or a solder in an initial molten (liquid) state. In other words, the component is flexibly secured to the substrate with the adhesive in the initial state.

By varying the pressure exerted by the liquid bump **257** on the component **251**, the component can be moved laterally with respect to the substrate. As discussed above, the pressure P exerted by the liquid bump can be changed, for example, by changing a gas, liquid or other fluid environment surrounding the liquid bump; by changing an electrical potential of the liquid bump; by changing a temperature of the liquid bump; by changing a volume of the liquid bump; by allowing oxidation of a surface of the liquid bump; by removing an oxide from a surface of the liquid bump; by changing a composition of the liquid bump; and/or by changing a wetted area of the substrate for the liquid bump.

Once the desired position of the component has been achieved, the adhesive can be transformed to a rigid state to rigidly secure the component to the substrate in the desired position while maintaining the liquid bump as a liquid. Once the component is rigidly secured, the liquid bump can be allowed to solidify or the liquid bump can be removed. If the adhesive is a curable epoxy, the component can be rigidly secured by curing the epoxy adhesive while maintaining the liquid bump in the liquid state at the desired pressure. If the adhesive is a solder, the component can be rigidly secured by cooling the solder adhesive to a solid state while maintaining the liquid bump in the liquid state at the desired pressure. If both the adhesive and the liquid bump are solder, for example, separate heaters in the substrate 253 can be used to separately heat the liquid solder bump and the solder adhesive so that the solder adhesive can be cooled to solidification while maintaining the liquid bump in the liquid state at the desired pressure. While multiple adhesive areas are illustrated in Figure 8, a single adhesive area could be used to secure the component to the substrate.

As illustrated in Figure 10, a pressure P of liquid bumps **287A-B** can be varied to adjust a vertical alignment of the component **281** with respect to the substrate **283**. As discussed above with regard to Figure 8, the pressure **P** exerted by the liquid bumps **287A-B** can be varied, for example, by changing a gas, liquid or other fluid environment surrounding the liquid bump; by changing an electrical potential of the liquid bump; by changing a temperature of the liquid bump; by changing a volume of the liquid bump; by allowing oxidation of a surface of the liquid bump; by removing an oxide from a surface of the liquid bump; by changing a composition of the liquid bump; and/or by changing a wetted area of the substrate for the liquid bump.

The adhesive **285** can flexibly secure the component **281** to the substrate **283** while the pressures **P** of the liquid bumps **287A-B** are varied to obtain a desired orientation of the component relative to the substrate. Once the desired orientation is achieved, the adhesive can be transformed to a rigid state to rigidly secure the component to the substrate in the desired orientation. In embodiments according to Figure 10, the pressure of the liquid bumps **287A-B** can be used to vary a vertical displacement of the component with respect to the substrate. A greater pressure of either bump **287A-B** can increase a displacement of the respective portion of the component relative to the substrate, and a lesser pressure of the either bump **287A-B** can decrease a displacement of the respective portion of the component relative to the substrate. The adhesive **285**, for example, can be solder, epoxy, or any other material that can provide flexible and then rigid adhesion as discussed above.

According to embodiments of the present invention illustrated in Figure 9, component **261** can be secured to substrate **263** using solder bumps **265A**-B, and positioning can be effected using solder bump **267**. Moreover, solder bumps **265A-B** can be heated and cooled using resistive heater elements **271 A-B**, while solder bump **267** can be heated and cooled independent of solder bumps **265A-B** using separate resistive heater element **273**. Accordingly, the solder bumps **265A-B** and **267** can be heated above their respective melting temperatures with the component **261** positioned on solder bumps **265A-B** and adjacent solder bump **267**. Defined wettable contact areas of the component **261** and defined wettable contact areas of the substrate **263** together with the solder bumps **265A-B** will provide a rough positioning of the component **261** relative to the substrate **263**.

A relatively fine lateral positioning of the component **261** can be effected by changing the pressure **P** exerted by the solder bump **267** on the component. As shown in Figure 9, the wire **269** can be used to apply an electrical potential to the solder bump **267** to vary the pressure **P** exerted by the solder bump **267** on the component **261**. Alternatively or in addition, the heat applied to the solder bump **267** by the heater element **273** can be varied above the melting temperature of the solder bump **267** to vary the pressure **P**. Once a desired position of the component is achieved by varying the desired property or properties of the liquid solder bump **267**, the heater elements **271A-B** can be turned off to solidify the solder bumps **265A-B** while maintaining the solder bump **267** as a liquid. Once the component **261** has been rigidly secured using solder bumps **265A-B**, the solder bump **267** can be allowed to solidify by turning the heater element **273** off. Liquids other than solder can be used as the liquid prime mover of bump **267**, and the liquid of bump **267** (whether solder or another liquid) does not need to be solidified. Embodiments according to Figure 9 can alternatively be implemented using a curable epoxy for bumps **265A-B** or other materials such that heater elements **271A-B** are not required wherein the epoxy bumps are cured to rigidly secure the component. Other liquids such as thermoplastics could be used.

As illustrated in Figure 11, a pressure **P** of liquid bumps **307A-B** can be varied to adjust a vertical alignment of the component **301** with respect to the substrate **303**. As discussed above with regard to Figure 9, the pressure **P** exerted by the liquid bumps **307A-B** can be varied by for example, by changing a gas, liquid or other fluid environment surrounding the liquid bumps; by changing an electrical potential of the liquid bumps; by changing a temperature of the liquid bumps; by changing a volume of the liquid bumps; by allowing oxidation of a surface of the liquid bumps; by removing an oxide from a surface of the liquid bumps; by changing a composition of the liquid bumps; and/or by changing a wetted area of the substrate for the liquid bumps.

The adhesive **305** can flexibly secure the component **301** to the substrate **303** while the pressures P of the liquid bumps **307A-B** are varied to obtain a desired orientation of the component relative to the substrate. Once the desired orientation is achieved, the adhesive **305** can be transformed to a rigid state to rigidly secure the component **301** to the substrate **303** in the desired orientation. In embodiments according to Figure 11, the pressure of the liquid bumps **307A-B** can be used to vary a vertical displacement of the component with respect to the substrate. A greater pressure of either bump **307A-B** can increase a displacement of the respective portion of the component **301** relative to the substrate, and a lesser pressure of the either bump **307A-B** can decrease a displacement of the respective portion of the component **301** relative to the substrate. The adhesive **305**, for example, can be solder, epoxy, or any other material that can provide flexible and then rigid adhesion as discussed above.

According to embodiments illustrated in Figure 11, each of liquid bumps **307A-B** and each of adhesive bumps **305** can be solder, with independent heater elements **309A-B** being provided within substrate **303** for each solder bump **307A-B**. The solder bumps **305** used for adhesion can be provided with heater elements **311** in substrate **303** that are independent of heater elements **309A-B**. Accordingly, each of the solder bumps **307A-B** and the solder bumps **305** can be heated above their respective melting temperatures using heater elements **311** and **313A-B** to allow positioning of the component by varying the pressures **P** of the solder bumps **307A-B**. The position of the component can be varied by varying the pressures **P** of one or more of solder bumps **307A-B**, and when the desired position is achieved, the heater elements **311** can be turned off to solidify the solder bumps **305** to secure the component in the desired position. Once the solder bumps **305** have been solidified, the heater elements **313A-B** can be turned off.

As shown in Figure 11, separate wires **309A-B** can be provided within substrate **303** to independently vary electrical potentials of the solder bumps **307A-B** to independently vary the pressures **P** thereof: Each wire **309A-B** can be coupled to a variable voltage source to vary the electrical potential of the respective bump to vary the surface tensions thereof. Alternatively, temperatures of solder bumps **307A-B** can be independently varied above the melting temperature of the solder using independent heater elements **313A-B** to independently vary the pressures thereof. If independent control of the pressures of solder bumps **307A-B** is not required or if the pressures are varied by means other than temperature, the heater elements **313A-B** need not be independent. Moreover, if an adhesive material other than solder is used for adhesive **305**, the heater elements **311** need not be provided. In addition, if a property other than electrical potential is used to vary the pressures of solder bumps **307A-B**, the wires **309A-B** need not be provided.

According to additional embodiments of the present invention, localized heating of a liquid bump can be used to change a displacement exerted by a portion of the liquid bump on a component. Different portions of an elongate liquid bump can be heated to different temperatures using multiple heater elements to increase or decrease a pressure exerted by a portion of the elongate liquid bump. In other words, movement of liquid in a liquid bump of constant volume on an unchanging wettable area of a substrate can be effected by differentially heating portions of the liquid bump to different temperatures according to a phenomena known as thermocapillarity or the Marangoni effect.

The surface tension of a liquid is dependant on its surface free energy and the free energy of the gas or liquid with which it is in contact. These free energies are functions of temperature and electrostatic potential, among other factors. Since the equilibrium shape depends on surface tension, varying the surface tension (e.g., by locally changing the temperature as in thermocapillarity) will change the equilibrium shape. The surface energy can also be varied by the application of an electrostatic field to cause the formation of an electric double layer, as in electrowetting or.electrocapillarity.

These effects can be used to create local widening or narrowing of elongate solder bumps that are constrained in two dimensions by a wettable area of a substrate surface. Local widening or narrowing of a solder bump using thermocapillarity can thus be used in positioning and alignment of components, such as optical components. Moreover, liquids other than solder can also be used.

According to embodiments illustrated in Figures 12A-E and 13A-E, one or more heater elements **319A-B** within substrate **325** can be used to provide localized heating of an elongate solder bump **321**. As shown in the top view of Figures 12A-E, an elongate solder bump **321** of relatively uniform thickness can be provided on a rectangular wettable area **323** of substrate **325**. When distributed uniformly as shown in Figures 12A-E, the solder bump **321** can have a hemispherical profile. The solder bump **321** can be heated uniformly above its melting temperature, for example, by heating the entire substrate in an oven or by generating a relatively uniform heat profile using the heater elements **319A-B** to produce a solder profile similar to that illustrated in Figures 12A-E.

As shown in Figures 13A-E, the heater element **319B** can be used to increase a temperature of the central portion of the liquid solder bump **321** with respect to the end portions of the solder bump. The resulting differences in surface tension across the solder bump **321** due to thermocapillarity can increase a thickness of the hottest portion of the liquid solder bump **321**. Alternatively, one of the heater elements **319A** or **319B** can be used to increase a temperature of an end portion of the solder bump **321** with respect to the rest of the solder bump thereby increasing a thickness of the end portion of the solder bump with respect to the rest of the solder bump. As shown, a plurality of heater elements can be used to create different temperature profiles across the solder bump to thereby create different physical profiles of the solder.

While a larger number of heater elements can provide a greater control of the resulting shape of the solder bump, a single heater element could be used to selectively heat a selected portion of the solder bump. Moreover, one or more heater elements can be used together with environmental heating (such as from an oven) wherein the environmental heating, for example, is used to melt the solder and wherein one or more heater elements can provide different temperature profiles for the bump. Alternatively, means other than resistive heater elements could be used to provide a varying temperature profile.

Thermocapillarity can thus be used to vary a displacement exerted by a liquid bump on a component thereby effecting movement of the component. A central portion of the elongate solder bump **321** illustrated in Figures 12A-E and 13A-E, for example, could be position adjacent a component on the substrate **325**, and an increase in the size of the central portion of the solder bump could be used to displace the component. Elongate solder bumps as illustrated in Figures 12A-E and 13A-E, for example, could be used in place of solder bumps **257, 267, 287A-B**, or **307A-B** of Figures 8-11. Moreover, elongate solder bumps as illustrated in Figures 12A-E and 13A-E can be used in combination with an adhesive such as solder or epoxy so that the adhesive flexibly secures the component while positioning and so that the adhesive rigidly secures the component once a desired position is achieved.

As shown in Figures 12A-E, a rectangular line coated with a hemispheric thickness of solder can have a uniform profile when uniformly heated above its melting temperature such that the solder is in an isothermal state. If additional heat is applied to center section, the surface tension of the center section can be reduced, and the radius of curvature can be reduced. Surface tension is discussed, for example, by N.K. Adam in *The Physics And Chemistry Of Surfaces* (Dover Publications, New York, 1968), the disclosure of which is hereby incorporated herein in its entirety by reference. In order for the radius of curvature to decrease the solder thickness of the warmer portion can become super-hemispheric and additional solder can flow into the warmer region, as shown in Figures 13A-E. This movement of liquid can be used to displace a component in contact therewith.

If the rectangular line is coated with a liquid that is sub-hemispheric on the wettable surface when in an isothermal state, the liquid may flow away from a warmer region to achieve a result that is opposite of that illustrated in Figures 12A-E and 13A-E. If, for example, heat is applied to the center section of the wetted surface, thereby decreasing the surface tension, then the liquid will flow away from the heat toward the cooler ends. In this situation, the radius of curvature can be increased in the heated region by lessening a height of the solder bump.

Calculations for a movement of solder as illustrated in Figures 12A-E and 13A-E are provided below. According to a particular example, an insulating portion of the substrate **325** adjacent the wettable area **323** may be an oxide having a thermal conductivity $\theta$ of 50.9watt/(mK); the wettable area **323** of the substrate may have a length L=1cm and a width W=0.25mm; and the heater element **319B** may have an electrical resistivity $\rho$=0.146X$10^{-6}$ohm- cm. At in initial uniform temperature $T_0$ across the elongate solder bump **321** of 233 C (506 K), the elongate solder bump **321** can have an initial radius of curvature $r_0$ of 0.75W (0.1875mm) and an initial surface tension $\sigma_{T0}$ of 493dyne/cm. The elongate solder bump can be heated to the initial temperature, for example, by heating the substrate in an oven or by generating a relatively uniform temperature profile across the bump using a plurality of heater elements **319A-C**.

A temperature of the center portion of the elongate solder bump can be increased with respect to the end portions of the elongate solder bump by providing additional power to the central heater element **319B**. The temperature of the center portion of the elongate solder bump, for example, can be increased to a second temperature $T_1$ = 280 C (553 K) while maintaining end portions of the elongate solder bump at the initial temperature $T_0$ = 233 C to provide a temperature differential $\Delta T$ of 47K.

Assuming that the temperature gradient appears across a distance of G=0.2L, the power P used to maintain a temperature differential of 47K can be calculated as follows:

$$P = \Delta T^* \theta^* \pi^* r_0^2 / (0.2L) = 0.132 \text{ watt.}$$

The radius of curvature of the heated zone can be calculated as:

$$r_H = r_0^* \sigma_{T1} \sigma /_{T0} = 178.753 \mu m,$$

and

$$\Delta r = r_H - r_0 = -8.747 \mu m.$$

The pressure can be calculated as:

$$\text{Pressure} = 2\sigma_{T1}/r_H = 0.763 \text{ psi.}$$

While embodiments of Figures 12A-E and 13A-E are discussed by way of example using solder, other liquids such as epoxies and thermoplastics can be used.

According to additional embodiments of the present invention, asymmetry in the shape of the wetted surface can be used to cause changes in the distribution of the liquid in response to changes in surface tension. A first dimension of a first portion of a wettable surface area can be wide relative to a second dimension of a second portion of the wettable surface area so that uniform heating of the wettable surface area can cause redistribution of a liquid thereon.

As shown in Figures 14A-C, a wettable surface area of a substrate **341** can have a first portion **343** having a first dimension that is wide relative to a second dimension of a second portion **345** of the wettable surface area. A liquid bump on the wettable surface area can have a corresponding first portion **347** that is wide relative to a second portion **349**. The substrate **341** can also include a single heater element **351** used to uniformly heat both portions of the liquid bump. When heated to a temperature between the melting and boiling points of the liquid, the height of the first portion **347** of the liquid bump will be greater than the height of the second portion **349** as a result of surface tension provided that a uniformly applied gravitational force is maintained, for example, in a horizontal position.

The surface tension of a liquid can be varied, however, as a function of temperature so that the difference in heights can be varied by varying the temperature. As the temperature of the liquid bump increases, the surface tension will decrease so that the differences in height will be reduced with increasing temperature between the melting and boiling temperatures. As the temperature of the liquid bump decreases, the surface tension will increase so that the differences in height will be increased with decreasing temperatures between the melting and boiling temperatures. In other words, the liquid can have a relatively high surface tension at the melting temperature so that the pressure driving the liquid from the narrow portion **349** to the wide portion **347** is greatest at a temperature just above the melting temperature. Conversely, the liquid can have nearly zero surface tension at the boiling temperature so that the pressure driving the liquid from the narrow portion **349** to the wide portion **347** is least at a temperature just below the boiling temperature of the liquid.

A single heater element **351** can thus be used to vary the heights of the liquid bump including the wide portion **347** and the narrow portion **349**. As shown in Figure 14B, the liquid bump can be heated to a first temperature T1 between the melting and boiling points of the liquid so that surface tension induced pressures cause the wide portion **347** to have a greater height than the narrow portion **349**. As shown in Figure 14B, the difference in heights can be increased by heating the liquid bump to a second temperature T2 between the melting temperature and T1. The liquid bump can thus be used to displace a component as discussed above. Either the wide portion **347** or the narrow portion **349** can be provided adjacent a component as shown, for example, in Figures 3 or 8-11 to provide variable positioning of a component dependent on the temperature of the liquid bump. While a single heater element **351** is illustrated in Figures 14A-C, the liquid bump can be heated by other means such as an oven.

The use of differential heating and asymmetric surface area can also be used in combination to provide a bi-stability effect. If two portions of a liquid bump have different widths and are heated differently, the liquid bump will be stable as long as the wide and narrow portions of the liquid bump are sub-hemispheric. If a temperature differential is used to drive liquid from the wide portion to the narrow portion of the bump to the extent that the narrow portion becomes super-hemispheric, however, a meta-stable condition could be achieved so that a height of the narrow portion actually exceeds a height of the wide portion of the liquid bump.

Because an internal pressure for a liquid bump is highest for a hemisphere on a constrained surface, there is a discontinuity in the slope of the dp/dv curve. In the curve shown in Figure 16, the internal pressure peaks when the radius of curvature of the bump is equal to the height of the bump (r=h) at which point the profile of the bump is a hemisphere. Therefore, if the liquid is made to move toward one end of the structure and the liquid at that end becomes super-hemispheric the system will switch to a new meta-stable state where most of the liquid moves to the end with lower pressure. If the new state is not too distant from the discontinuity, differential pressure caused by thermocapillarity could be used to switch back to the initial state.

As shown in Figures 15A-C, a wettable surface area of a substrate **361** can have a first relatively wide portion **363** and a second relatively narrow portion **365**, and the liquid bump thereon can have a corresponding wide portion **367** and a corresponding narrow portion **369**. Heater elements **371** and **373** can be used to differentially heat the wide and narrow portions of the liquid bump.

As shown in Figure 15B, if both the wide and narrow portions of the liquid bump are sub-hemispheric and heated to a common temperature between the melting and boiling temperatures of the liquid, the height of the wide portion **367** will be greater than a height of the narrow portion **369** as a result of surface tension. The heater elements **371** and **373** can be used to heat the narrow portion **369** to a temperature greater than that of the wide portion so that liquid flows from the wide portion **367** to the narrow portion **373**. If enough liquid can be transferred from the wide portion to the narrow portion so that the radius of the narrow portion is greater than or equal to the height of the narrow portion, a meta-stable condition can be achieved so that the height of the narrow portion **369** is significantly greater than the height of the wide portion **367**, as shown in Figure 15C.

Once the condition of Figure 15C is achieved, a temperature differential is not required to maintain the condition. In fact, a reverse temperature differential may be required to get liquid to flow from the narrow portion **369** back to the wide portion **367**. The reverse temperature differential must be sufficient to overcome the pressure curve illustrated in Figure 16. Moreover, the liquid bump in the meta-stable condition of Figure 15C can be cooled to solidification while maintaining the relative heights of the wide and narrow portions.

The meta-stable condition discussed above with regard to Figures 15A-C can also be used to move liquid between connected portions of equal surface area and surface dimensions as shown, for example, in Figures 17A-C. As shown in Figures 17A-C, a patterned wettable layer may include wettable areas **401** and **403** of equal surface area and a relatively narrow channel **405** therebetween on a substrate **399**, and solder bumps **407** and **409** can be provided on the wettable areas **401** and **403**. The substrate **399** can also include heater elements **411** and **413** therein to differentially heat the solder bumps **407** and **409**.

The heater elements **411** and **413** can thus be used to differentially heat the solder bumps to alternatingly create the meta-stable condition of Figure 17B where solder bump **409** is super-hemispheric and solder bump **407** has relatively little solder thereon and the meta-stable condition of Figure 17C where solder bump **407** is super-hemispheric and solder bump **409** has relatively little solder thereon. As discussed above, the initial temperature differential used to achieve either meta-stable condition is not required to maintain the respective condition, and the solder can be cooled to solidification while maintaining either meta-stable condition.

The structure of Figures 17A-C can thus be used as a kind of a physical latch. Each solder bump **407** and **409** can thus be used to selectively interrupt or reflect a respective light path **417** and **419**. The light path **417** between optical components **421** and **425** can be maintained in the meta-stable condition of Figure 17B where relatively little solder is left for bump **407**, and the light path **417** can be interrupted in the meta-stable condition of Figure 17C where the solder bump **407** is super-hemispheric. Conversely, the light path **419** between optical components **423** and **427** can be interrupted in the meta-stable condition of Figure 17B where the solder bump **409** is super-hemispheric and the light path **419** can be maintained in the meta-stable condition of Figure 17C where relatively little solder is left for bump **409**.

Instead of merely interrupting a light path between two optical components, a liquid bump can alternatively he used to selectively maintain a light path between first and second components or to provide a reflected light path between the first component and a third component depending on the size of the bump. A liquid bump can also be used to selectively provide one of a plurality of reflected light paths depending on the size of the bump.

While two light paths are illustrated in Figures 17A-B, a single light path could be manipulated with one of the solder bumps. Moreover one or both of the liquid bumps could be used to position components on a substrate instead of or in addition to modulating a light path. Moreover, a light path could be manipulated using liquid movements other than those illustrated in Figures 17A-C. Liquid movements according to any of the techniques discussed above could be used to manipulate a light path.

If the liquid is initially equally distributed between the portions and the profile is initially sub-hemispheric on each portion, a temperature differential can be used to make liquid flow from a first portion to the second portion. If enough liquid can be caused to flow such that the second portion reaches a hemispheric profile, the meta-stable condition can be obtained such that liquid will not flow back to the first portion without applying a reverse temperature differential of sufficient magnitude to the system. With two ends of equal wetted area there would be no preferred end and the switching can be more uniform. The moving liquid could be used to block a beam of light or exert a force to move a component.

In the examples discussed above, a liquid bump can be solder or other liquid materials such as epoxies, thermoplastics, oleic acid, etc. In the case of epoxies, the curing by chemical or UV radiation could harden the liquid in a desired position. The component being positioned could be supported by liquid solder or epoxy during the positioning and subsequently solidified when proper position is attained. In this instance, the motive liquids need not undergo a phase transition to secure the component in position.

If the liquid is electrically conductive, the surface tension can be varied by the applications of voltage to the liquid with respect to the substrate or a surrounding electrolyte, thus producing effects similar to those of thermocapillarity. The use of voltage to vary surface tension is discussed, for example, by A. Frohn et al. in *Dynamics of Droplets* (Springer Verlag, New York, 2000), the disclosure of which is incorporated herein in its entirety by reference.

Liquid bumps can be used as discussed above to provide precise positioning of components. For example, a liquid bump can be used as a prime mover to position a component during an assembly of an electronic, optical, and/or mechanical system after which the component is maintained in the assembled position. Liquid bumps can also be used to provide continuous dynamic alignment during and/or after use of such an assembly. Liquid bumps, for example, can be used as liquid prime movers to manipulate mirrors and/or lasers and/or to selectively interrupt and/or deflect an optical path during use of an optical system. Alternatively, liquid prime movers can be used to reposition a component of a system after some period of use to compensate for effects of aging and/or use.

In the drawings and specification, there have been disclosed typical preferred embodiments of the invention and, although specific terms are employed, they are used in a generic and descriptive sense only and not for purposes of limitation, the scope of the invention being set forth in the following claims.

**Claims**

1. A method of manipulating a light path between two optical components, the method comprising:

   providing a liquid material on a wettable area of a substrate so that the liquid material forms a bump on the wettable area; and
   changing a height of the liquid bump between a first height and a second height so that the liquid bump interrupts the light path at the first height of the liquid bump and so that the light path is not interrupted at the second height of the liquid bump.

2. A method according to Claim 1 wherein changing a height of the liquid bump comprises differentially heating the liquid bump.

3. A method according to Claim 1 wherein the wettable area of the substrate comprises first and second portions of different dimensions and wherein changing a height of the liquid bump comprises changing temperatures of the liquid on the first and second portions from a first common temperature to a second common temperature.

4. A method according to Claim 1 wherein the wettable area of the substrate comprises first and second portions and wherein changing a height of the liquid bump comprises moving portions of the liquid from the first portion of the wettable area to the second portion of the wettable area.

5. A method according to Claim 4 wherein the first and second portions of the wettable area are coupled by a wettable channel that is narrow with respect to the first and second portions of the wettable area.

6. A method according to Claim 5 wherein moving portions of the liquid comprises differentially heating the first and second portions of the wettable area.

7. A method according to Claim 1 wherein the wettable area of the substrate comprises first and second portions of different dimensions and wherein changing a height of the liquid bump comprises changing an electrical potential of the liquid on the first and second portion from a first common potential to a second common potential.

8. An optical structure comprising:

   first and second elongate liquid bumps on a substrate wherein the first and second elongate liquid bumps are parallel; and
an optical fiber in contact with and between the first and second elongate liquid bumps.

9. An optical structure according to Claim 8 wherein the first and second elongate liquid bumps are constrained on corresponding first and second wettable areas of the substrate and wherein the first elongate liquid bump is significantly larger than the second elongate liquid bump.

10. An optical structure according to Claim 8 wherein the first and second elongate liquid bumps have substantially the same dimensions.

11. An optical structure comprising:

an optical component that generates an optical output along an optical path; and
a liquid bump in the optical path wherein the liquid bump is adapted to selectively transmit and interrupt or reflect the optical output.

12. An optical structure according to Claim 11 further comprising:

a second optical component in the optical path wherein the second optical component receives the optical output when the optical output is transmitted past the liquid bump and wherein the second optical component does not receive the optical output when the optical output is interrupted or reflected by the liquid bump.

Figure 1A

Figure 1B

Figure 1C

Figure 2A

Figure 2B

Figure 2C

Figure 3

Figure 4A

Figure 4B

Figure 4C

Figure 4D

Figure 5

Figure 6A

Figure 6B

205A  205B  203A  201  203B  205C
209A  209B  209C  209D  205D
207
204A  204B  204C  204D  209

Figure 6C

203A  203B
205A 209A 205B  201  205C  205D
209B  209D  207
204A  204B  204C  204D  209

Figure 6D

203A  201  203B
211A 213A 211B 213B  213C  213D
214C  211D  207
214A  214B  214C  214D  209

Figure 6E

203A  203B  213D
201  211C  211D
211A 213A 211B 213B  207
209
214A  214B  214C  214D

Figure 7

221

223A
223B
223C
223D
223E
223F
223G
223H
223I
223J.
223K
223L
225
227

Figure 8

257 255 251 255 253 P

Figure 9

267 265A 261 265B 263 P
269 273 271A 271B

Figure 10

273 285 285 281
287A 287B
283

Figure 11

305 305 301
307A 307B
309A 309B
313A 311 311 313B 303

Figure 12 A

Figure 12B

Figure 12C

Figure 12D

Figure 12E

Figure 13 A

Figure 13B

Figure 13C

Figure 13D

Figure 13E

Figure 14A

347 349 341 351

Figure 14B

347 349 343 345 341 351

Figure 14C

347 349 343 345 341 351

Figure 15A

367    369

361

Figure 15B

367    369

363    365

361

371    373

Figure 15C

367    369    365

363

361

371    373

Figure 16

Internal Pressure vs. Bump Height

— r=0.050mm
· · r=0.100mm
— r=0.200mm

Figure 17A

725    427

409

407

399

407    411    417    421    423    413    419

Figure 17B    407    409

401    403

399

407    411    405    413

Figure 17C    407    409

401    403

399

411    405    413